# EUROPEAN PATENT APPLICATION

(11) **EP 2 782 154 A1**
(43) Date of publication of application: **24.09.2014**
(21) Application number: 12849724.5
(22) Date of filing: 16.11.2012
(51) Int. Cl.: H01L 51/50, H05B 33/10, H05B 33/14

(54) **ORGANIC LIGHT-EMITTING ELEMENT AND METHOD FOR PRODUCING ORGANIC LIGHT-EMITTING ELEMENT**

(30) Priority: 18.11.2011 JP 2011252293
(71) Applicant: Showa Denko K.K., Tokyo 105-8518 (JP)
(72) Inventor: YAMAZAKI, Yusuke, Minato-ku, Tokyo 1058518 (JP); MASUYA, Kyousuke, Minato-ku, Tokyo 1058518 (JP)
(74) Representative: Strehl Schübel-Hopf & Partner
(86) International application number: PCT/JP2012/079796
(87) International publication number: WO 2013/073670

(57) **Abstract**

An organic light-emitting element (10) includes: a substrate (110); plural first conductive layers (120) formed spaced by gaps on the substrate (110) and electrically isolated from each other; a second conductive layer (130) including plural regions (132) isolated from each other and formed on the first conductive layer (120) and on sections of the substrate (110) at which the gaps are provided; an organic compound layer (140) including a light-emitting layer and laminated on the plural regions (132) of the second conductive layer (130) formed on at least the first conductive layer (120); and a third conductive layer (150) formed on at least the organic compound layer (140). Further, in the organic light-emitting element (10), at least two regions (132) of the second conducive layer (130) are respectively formed on each of the first conductive layers (120) at the light-emission region at which the first conductive layer (120) and the third conductive layer (150) overlap in a plan view, and each of the regions (132) of the second conductive layer (130) contacts only any one of the first conductive layers (120) or is electrically isolated from all of the first conductive layers (120).

## Description

### Technical Field

The present invention relates to an organic light-emitting element used for a display device or an illumination device and a method for producing an organic light-emitting element.

### Background Art

An organic light-emitting element has been expected to be applied to a dot-matrix display, an illumination device or the like in recent years, for the organic light-emitting element has an excellent feature of self-light emission or lower power consumption. In general, the organic light-emitting element has a configuration in which a light-emitting layer that is formed by making an organic compound including a light-emitting material thin-film like is sandwiched by an anode electrode and cathode electrode, and a voltage is applied between the electrodes to couple holes and electrons in a light-emitting layer, thereby the light-emitting material is excited to emit light.

In the dot-matrix display or the illumination device using the organic light-emitting element, a conductive pattern which includes conductive materials such as an electrode, a wiring, an electrode terminal and the like is formed on a transparent substrate and a light-emitting layer and an opposite electrode are laminated on the conductive pattern. For example, in Patent Documents 1 and 2, displays are disclosed in which a light-emitting layer and a cathode are laminated on plural anodes in stripe-like shape which is composed of indium tin oxide (ITO) formed on a glass substrate.

Here, a technique is known in which forming a conductive layer composed of a conductive material such as a conductive polymer and the like between an anode and a light-emitting layer improves the light-emitting efficiency and the stability of an organic light-emitting element. Since electrical conductivity of a conductive polymer is high, when the conductive layer is formed on a whole surface on the anodes and between the anodes, there are problems that bleeding is caused so that images become blurred by light-emission of the light-emitting layers between the anodes, cross talks are caused so that conduction between the anodes or between the wirings is caused and the unintended pixels come to emit light, and perhaps short circuits between the anodes and the cathode terminals are caused and pixels come not to emit light at all.

To address such a problem, in Patent Document 1, it is disclosed that leakage of current between the pixels is suppressed and an occurrence of cross talks is prevented by removing hole-transporting layers which are conductive layers and formed on dividing walls between anodes with a method such as detachment, laser ablation and the like. Moreover, in Patent Document 2, it is disclosed that electrical connections among anodes adjacent to each other are avoided and cross talks are suppressed by executing, with photoresist pattern, a processing to selectively lower ratio of electrical conductivity of the conductive layers composed of conductive polymers formed between the anodes.

### Citation List

### Patent Literature

Patent Document 1: Japanese Patent Application Laid-Open Publication No. 2008-243559
Patent Document 2: Japanese Patent Application Laid-Open Publication No. H11-195491

### Disclosure of Invention

### Technical Problem

However, for example, since the intervals between anodes are narrow in a high definition display, it is difficult to selectively remove the conductive layers between anodes with high positional accuracy or to perform a deforming processing. Thus, it is not easy to manufacture a display in which there are no problems about cross talks or bleeding.

In the case where the conductive layers on plural substrates that have different patterns of anodes and wirings from each other, there is a problem that manufacturing processes are complicated such that photomasks corresponding to the respective patterns are required and the like. Especially it is a big problem in a method for manufacturing including a process in which one substrate is cut with respect to each unit after forming plural displays or plural illumination units on a single substrate.

The purpose of the present invention is to provide an organic light-emitting element and a method for manufacturing the organic light-emitting element in which the problems of cross talks or bleeding are not caused also in the case where the intervals between anodes are narrow.

### Solution to Problem

As a result of an earnest consideration to address the above problem, the present inventors have found that it is possible to easily manufacture displays or lighting devices which have no cross talks, bleeding or short circuits without impairing the performance of the organic light-emitting element, by forming a conductive layer that includes plural regions on the whole surface including portions on and between the anodes, thereby completed the present invention.

According to the present invention, an organic light-emitting element including: a substrate; plural first conductive layers that are formed spaced by gaps on the substrate and electrically isolated from each other; a second conductive layer that includes plural regions isolated from each other and are formed on the first conductive layers and on sections of the substrate at which the gaps are provided; an organic compound layer that includes a light-emitting layer and is laminated on the plural regions of the second conductive layer formed on at least the first conductive layers; and a third conductive layer that is formed on at least the organic compound layer, wherein at least two regions of the second conducive layer are respectively formed on each of the first conductive layers at a light-emission region at which the first conductive layers and the third conductive layer overlap in a plan view, and each of the regions of the second conductive layer contacts only any one of the first conductive layers or is electrically isolated from all of the first conductive layers, is provided.

Here, it is preferable that the plural regions of the second conductive layer are regions in which the plural regions with same or different shape or the plural regions with same or different area are regularly arranged.

It is preferable that a width of each of the regions of the second conductive layer is smaller than the minimum width of each of the gaps at a section corresponding to the gaps spacing the first conductive layers.

It is preferable that the maximum width of each of the regions of the second conductive layer is smaller than the minimum width of each of the gaps electrically isolating the first conductive layers from each other.

It is preferable that the second conductive layer is a layer in which the plural regions with same shape are regularly arranged in a plane of the second conductive layer.

It is preferable that at least ten of the regions of the second conductive layer are formed on each of the first conductive layers corresponding to sections at which the first conductive layers and the third conductive layer overlap in a plan view.

It is preferable that at least one of the first conductive layers is an anode electrode and the second conductive layer on the anode electrode is a hole-injection layer.

It is preferable that at least one of the first conductive layers contacts the third conductive layer or the second conductive layer on the first conductive layers contacts the third conductive layer.

It is preferable that a dielectric layer in which plural passing-through portions are provided is formed in at least a part between the first conductive layers and the second conductive layer, and the second conductive layer contacts the first conductive layer in the passing-through portions of the dielectric layer.

It is preferable that each of the passing-through portions of the dielectric layer has a circular or polygonal shape with the maximum width of not more than 10 µm in an arbitrary surface of the first conductive layer.

It is preferable that each of the passing-through portions of the dielectric layer is formed 10² to 10⁸ per 1 mm square in an arbitrary surface of the first conductive layers.

Further, according to the present invention, a method of producing an organic light-emitting element including: a process in which plural first conductive layers spaced by gaps and electrically isolated from each other are formed on a substrate; a process in which a non-patterned conductive layer that is different from the first conductive layers and is formed on the first conductive layer and on sections of the substrate corresponding to the gaps; a process in which the non-patterned conductive layer is patterned to form a second conductive layer including plural regions isolated from each other on the first conductive layers and on sections of the substrate at which the gaps are provided; a process in which an organic compound layer that contacts the second conductive layer and includes a light-emitting layer is formed above at least one of the first conductive layers; and a process in which a third conductive layer is formed on the organic compound layer, wherein at least two regions of the second conducive layer are respectively formed on each of the first conductive layers at a light-emission region at which the first conductive layers and the third conductive layer overlap in a plan view, and each of the regions of the second conductive layer contacts only any one of the first conductive layers or is electrically isolated from all of the first conductive layers, is provided.

Still further, according to the present invention, a method of producing an organic light-emitting element including: a process in which plural first conductive layers spaced by gaps and electrically isolated from each other are formed on a substrate; a process in which a second conductive layer that is patterned and includes plural regions formed on the first conductive layers and on sections of the substrate corresponding to the gaps and isolated from each other; a process in which an organic compound layer that contacts the second conductive layer and includes a light-emitting layer is formed above at least one of the plural the first conductive layers; and a process in which a third conductive layer is formed on the organic compound layer, is provided.

Here, it is preferable that at least two regions of the second conducive layer are respectively formed on each of the first conductive layers, and each of the regions contacts only any one of the first conductive layers or is electrically isolated from all of the first conductive layers.

It is preferable that an organic light-emitting element including the plural first conductive layers, the second conductive layer, the organic compound layer and the third conductive layer, and at least two light-emitting devices including a terminal for applying voltage to the organic light-emitting element are formed, and the substrate is cut with respect to each light-emitting device after the third conductive layer is formed.

It is preferable that the second conductive layer is formed at a section between the light-emitting devices adjacent to each other on the substrate.

### Advantageous Effects of Invention

According to the present invention, even when intervals between the anodes are narrow like a high-definition display, an organic light-emitting element in which a conductive layer maintaining insulation between the anodes is formed without performing a high-accuracy position control and has no problems such as cross talks and bleedings can be provided.

Moreover, it is possible to form a conductive layer without modification of photomask and manufacturing process, as to plural substrates which have different patterns of anodes or wirings.

Further, since it is possible to easily form a conductive layer which has no problems of cross talks and bleedings on a substrate with large area, it comes to be easy to manufacture by cutting with respect to each unit after forming plural display units and plural illumination units on one substrate, thus, productivity is hugely improved.

### Brief Description of Drawings

FIGS. 1A and 1B are schematic views for illustrating a specific example of an organic light-emitting element to which the first exemplary embodiment is applied;
FIGS. 2A to 2F are diagrams for illustrating specific examples of shapes of plural regions which form a second conductive layer and are isolated from each other;
FIGS. 3A to 3D are diagrams for explaining a relationship between a first gap and a size of the plural regions of the second conductive layer;
FIGS. 4A and 4B are schematic views for illustrating a specific example of an organic light-emitting element to which the second exemplary embodiment is applied;
FIG. 5 is a schematic view for illustrating a specific example of an organic light-emitting element to which the third exemplary embodiment is applied; and
FIGS. 6A to 6D are diagrams for illustrating a specific example of a method of producing the organic light-emitting element.

### Description of Embodiments

Hereinbelow, an exemplary embodiment according to the present invention will be described in detail. It should be noted that the present invention is not limited to the following exemplary embodiment, however may be practiced as various modifications within the scope of the gist of the invention. Further, each of the figures to be used indicates a specific example for illustration of the exemplary embodiment, and does not represent an actual size thereof.

### <First exemplary embodiment>

### (Organic light-emitting element)

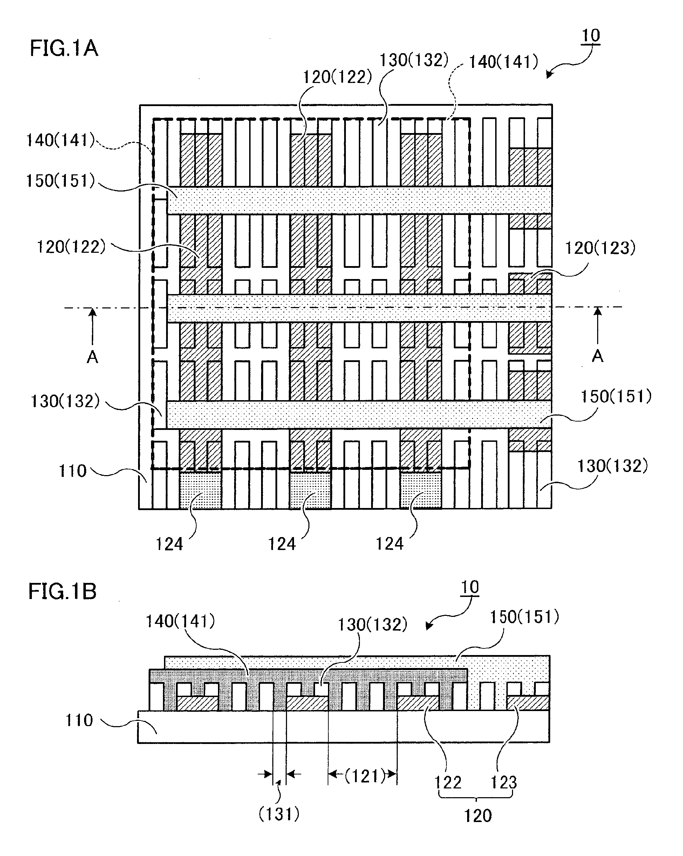

FIGS. 1A and 1B are schematic views for illustrating a specific example of an organic light-emitting element 10 to which the first exemplary embodiment is applied. FIG. 1A is a planar schematic view and FIG. 1B is a schematic view of A-A cross section.

Hereinafter, the organic light-emitting element 10 will be explained based on FIGS. 1A and 1B.

As shown in FIGS. 1A and 1B, the organic light-emitting element 10 includes a substrate 110 which is plane-like, plural first conductive layers 120 which are formed spaced by gaps on the substrate 110 and electrically isolated from each other, a second conductive layer 130 which includes plural regions 132 isolated from each other and are formed on the first conductive layers 120 and on the sections corresponding to gaps isolating the first conductive layers 120, an organic compound layer 140 which includes a light-emitting layer 141 and laminated above at least one of the first conductive layers 120, and a third conductive layer 150 formed so as to cover at least a surface of the organic compound layer 140.

Here, the gaps for electrically isolating the plural first conductive layers 120 are denoted as first gaps 121. Plural regions 132 of the second conductive layer 130 are isolated from each other by second gaps 131. Note that, in the present exemplary embodiment, the second gap 131 preferably has a narrower width than a width of the first gap 121.

The first conductive layer 120 includes plural anode electrodes 122 which are rectangular shape and are arranged on the substrate 110 in substantially parallel to each other with the first gaps 121 provided therebetween, a cathode terminal 123 which has a shorter length compared with a length of the anode electrode 122 in a longitudinal direction and is arranged on an edge portion of the substrate 110 in substantially parallel to the anode electrode 122. Here, the plural anode electrodes 122 and the cathode terminal 123 of the first conductive layer 120 are electrically insulated from each other. Moreover, as shown in FIG. 1A, the longitudinal end of the respective anode electrodes 122 of the first conductive layer 120 is formed toward the edge portion of the substrate 110, and the portions formed at the edge portions are the anode terminals 124.

The plural regions 132 of the second conductive layer 130 are rectangular shape having a narrower width in a lateral direction compared to width of the anode electrodes 122 of the first conductive layer 120, and are arranged in substantially parallel to the anode electrodes 122 by being provided the second gaps 131 therebetween, which have a narrower width than the first gaps 121. In the exemplary embodiment, as shown in FIG. 1B, at least two of the regions 132 are formed on one of the anode electrodes 122 (the first conductive layer 120).

Note that, all of the respective plural regions 132 may be formed on the first conductive layers 120, or a part of one of the regions 132 may be formed extending on the first gap 121. Further, in addition to this, the plural regions 132 may be formed only on the sections corresponding to the first gaps 121 of the substrate 110.

By forming the respective regions 132 of the second conductive layer 130 as described above, among the respective regions 132 of the second conductive layers 130, only the regions 132 contacting the first conductive layer 120 are applied current just in the case where the first conductive layer 120 is applied voltages.

Moreover, when one of the anode electrodes 122 or the cathode terminal 123 of the first conductive layer 120 are applied voltages, the anode electrodes 122 or the cathode terminal 123, which are adjacent to each other through the second conductive layer 130, are not applied voltages, since the second conductive layer 130 is isolated by the plural regions 132 and the respective plural regions 132 are not formed extending over between the anode electrodes 122 or over between the anode electrode 122 and the cathode terminal 123.

Note that, in FIG. 1A and FIG.1B, the second conductive layer 130 is formed on the cathode terminals 123, or on the anode terminals 124 and the first gaps 121. However, it is not always necessary, and the second conductive layer 130 is necessarily formed on at least the anode electrodes 122.

The organic compound layer 140 are laminated so as to cover the plural anode electrodes 122 of the first conductive layer 120, the sections corresponding to the first gaps 121 of the substrate 110, the plural regions 132 of the second conductive layers 130, and the sections corresponding to the second gaps 131. In the present exemplary embodiment, the plane-shape of the organic compound layer 140 is formed into a rectangular shape having a side substantially parallel to the longitudinal direction of the anode electrode 122 having rectangular shape, and formed so as to cross-sectionally cover the plural anode electrodes 122 and the plural regions 132.

In FIGS. 1A and 1B, a portion where the three layers of the first conductive layer 120, the second conductive layer 130 and the third conductive layer 150 overlap in a plan view is the light-emitting region. The respective light-emitting regions may be divisionally formed with various materials for the purpose of distinguishing the light-emitting color and driving control, or the like. Moreover, the organic compound layer 140 may be formed on at least the light-emitting regions.

The third conductive layer 150 is formed on a surface of the organic compound layer 140 as a cathode electrode 151. As shown in FIG. 1A, the cathode electrodes 151 have a rectangular shape and are arranged so that the longitudinal direction thereof is at substantially orthogonal to the plural anode electrodes 122 of the first conductive layer 120 and the plural regions 132 of the second conductive layer 130. Moreover, as shown in FIG. 1B, in the cathode terminals 123 of the first conductive layer 120, the third conductive layer 150 contacts the first conductive layer 120 directly or through the regions 132 of the second conductive layer 130.

Hereinafter, each component of the organic light-emitting element 10 will be explained.

### (Substrate 110)

The substrate 110 is a support body for forming the first conductive layer 120 including the anode electrode 122 and the cathode terminal 123, the second conductive layer 130, the organic compound layer 140, and the third conductive layer 150. A material which satisfies the mechanical strength required for the organic light-emitting element 10 is used for the substrate 110.

The material for the substrate 110 is, in the case where the light is to be extracted from the substrate 110 side of the organic light-emitting element 10, required to be transparent to the visible light. Specific examples include: glasses such as sapphire glass, soda glass and quartz glass and the like; transparent resins such as acrylic resins, methacrylic resins, polycarbonate resins, polyester resins, nylon resins, silicon resins and the like; metallic nitride such as aluminum nitride and the like; and transparent metallic oxide such as alumina and the like.

In the case of using, as the substrate 110, a resin film or the like made of the aforementioned transparent resins, it is preferable that permeability to gas such as moisture and oxygen is low. In the case of using a resin film or the like having high permeability to gas, a thin film having a barrier property for inhibiting permeation of gas is preferably formed within a scope which does not impair the light transmission.

In the case where it is not necessary to extract the light from the substrate 110 side of the organic light-emitting element 10, the material of the substrate 110 is not limited to the ones which are transparent to the visible light, and may be opaque to the visible light. Specific examples include: in addition to the above-described materials, simple substances such as silicon (Si), copper (Cu), silver (Ag), gold (Au), platinum (Pt), tungsten (W), titanium (Ti), tantalum (Ta) and niobium (Nb); alloys thereof; stainless steel; oxides such as SiO₂, Al₂O₃ or the like; semiconductors such as n-Si and the like.

In the case where a metal is used for the substrate 110, it is preferable that the substrate 110, the first conductive layer 120, and the second conductive layer 130 are insulated. The thickness of the substrate 110, depending on the required mechanical strength, is arbitrarily selected. In the present exemplary embodiment, the thickness of the substrate 110 is preferably 0.01 mm to 10 mm, and more preferably 0.1 mm to 2 mm.

### (First conductive layer 120)

The anode electrode 122 and the cathode terminal 123 of the first conductive layer 120 are formed with a vacuum deposition method or a sputtering method using a same materials on the substrate 110. Note that, the plural first conductive layers 120 may be formed by performing a patterning at the time of film-forming, or the plural first conductive layers 120, which are electrically isolated from each other by the first gaps 121, may be formed by performing an etching and the like.

Width of the first gaps 121 between the anode electrodes 122 and between the anode electrode 122 and the cathode terminal 123 is not particularly limited, however, in the present exemplary embodiment, the width is in the range of 1 µm to 5 mm, preferably 10 µm to 2 mm. Note that, in the case of a display device such as a display and the like, width of the anode electrode 122 in the lateral direction is, in the present exemplary embodiment, in the range of 1 µm to 1000 µm, preferably 10 µm to 500 µm, more preferably 50 µm to 300 µm.

The cathode terminal 123 is formed as a terminal of a cathode extracting electrode which may apply a voltage to the cathode electrode 151 when the cathode terminal 123 is applied voltage, by contacting the cathode electrode 151, which is the third conductive layer 150, through the second conductive layer 130 or directly.

On the other hand, in the present exemplary embodiment, the anode electrode 122 is connected to the anode terminal 124 formed as a terminal of an anode extracting electrode at the edge portion of the substrate 110. Holes are injected into the organic compound layer 140 from the anode electrode 122 by applying voltages between the anode electrode 122 and the cathode electrode 151 via the terminal of the cathode extracting electrode and the terminal of the anode extracting electrode. A material used for the cathode terminal 123 and the anode electrode 122 is preferably the ones which has electric conductivity and has a sheet resistance of not more than 1000Ω/sq, more preferably not more than 100Ω/sq in temperature range of -5°C to 80°C. Specifically, the material is the one which has a large work function as the anode electrode 122, and the work function is preferably not less than 4.5eV.

As specific examples satisfying such the requirements, metallic oxides, metals, alloys are provided. Here, as specific examples of metal oxides, ITO (indium tin oxide) and IZO (indium zinc oxide) are provided. Also specific examples of metal include: copper (Cu), silver (Ag), gold (Au), platinum (Pt), tungsten (W), titanium (Ti), tantalum (Ta) and niobium (Nb) and the like. Further, alloys thereof, stainless steel or the like may be used.

The thickness of the first conductive layer 120 is preferably in the range of 2 nm to 2 µm, more preferably 20 nm to 500 nm, further preferably 50 nm to 250 nm. Surface resistance tends to be high, if the thickness is too thin, and light transmittance tends to be low if the thickness is too thick. Note that, the work function can be measured by, for example, an ultraviolet photoelectron spectroscopy.

Performing surface treatment on the substrate 110 or the first conductive layer 120 improves performance (for example, adhesion to the anode electrode 122, surface smoothness, hole-injection barrier and the like) of the overcoated layer. As the surface treatment, firstly high-frequency plasma treatment, sputtering treatment, corona treatment, UV (ultraviolet) ozone irradiation treatment, ultraviolet irradiation treatment, oxide plasma treatment or the like are provided.

### (Second conductive layer 130)

In the present exemplary embodiment, the second conductive layer 130 has a property of a carrier injection layer. Here, the carrier injection layer is a layer which has a function of injecting carriers from an electrode, and the carrier injection layer becomes a hole-injection layer in the case where the first conductive layer 120 on the substrate 110 is an anode, the carrier injection layer is an electron-injection layer in the case where the first conductive layer 120 on the substrate 110 is a cathode. In the present exemplary embodiment, the first conductive layer 120 has the anode electrodes 122, and the second conductive layer 130 is formed as a hole-injection layer.

The second conductive layer 130 as a hole-injection layer is formed by using a hole-injection material publicly known. Specific examples include: conductive polymers such as polyacetylene, polyparaphenylene, polyaniline, polythiophene, polyparaphenylenevinylene, and the like; organic compounds such as arylamine, phtalocyanine, and the like; oxide productions such as vanadium oxide, zinc oxide, molybdenum oxide, ruthenium oxide, titanium oxide, and the like. These materials improve conductivity by being doped with carriers or being injected carriers which freely move.

The hole-injection material may be used solely or by mixing two or more. Further, hole-injection materials which are different from each other may be used by being laminated. Specific examples of using dopants include: a mixture (PEDOT/PSS) of poly(3,4)-ethylendioxythiophene (PEDOT) and polystylene sulfonate (PSS), a mixture (PANI/PSS) of polyaniline (PANI) and polystylene sulfonate (PSS), and the like.

Since it is known that the light-emitting efficiency and reliability of an organic light-emitting element is improved by forming a conductive layer of high conductivity, it is more preferable as the conductivity of the second conductive layer 130 is higher. In general, a layer which has low sheet resistance tends to have high conductivity, therefore the sheet resistance of the second conductive layer 130 is preferably not more than 3 GΩ/sq, more preferably not more than 1 GΩ/sq.

If the sheet resistance of the second conductive layer 130 is too high, function of injecting charges is declined, and decrease of light-emitting efficiency or brightness tends to be caused due to increase of driving voltages.

The thickness of the second conductive layer 130 depends on conductivity and the like as a hole-injection layer and is not particularly limited, however, in the present exemplary embodiment, preferably 0.5 nm to 1 µm, more preferably 1 nm to 500 nm, further preferably 2 nm to 300 nm. If the thickness of the second conductive layer 130 is too thin, sheet resistance gets large, while it is not preferable if the thickness of the second conductive layer 130 is too thick because the entire thickness of the organic light-emitting element 10 is thick.

Note that, in the case where the second conductive layer 130 is provided in the direction of light extraction, it is preferable to select thickness or a material having optical permeability. Moreover, materials for the second conductive layer 130 may be the same materials on the entire surface or different materials from each other.

The plural regions 132 of the second conductive layer 130 may be formed on at least the first conductive layer 120 (the anode electrodes 122) which is a light-emitting surface and may be formed extending to the entire surface of the substrate 110. For example, the plural regions 132 may be formed on the entire surface of the top of the substrate 110 except for the cathode terminal 123. Moreover, on the top of the anode terminal 124 and on the cathode terminal 123, the second conductive layer 130 may be formed or not. Moreover, as to the plural regions 132 of the second conductive layer 130, one of the regions 132 may be formed on both of the first conductive layer 120 (the anode electrode 122) and the sections corresponding to the first gaps 121 of the substrate 110, or only on the substrate 110, or only on the first conductive layer 120 (the anode electrode 122).

In the present exemplary embodiment, as to the second conductive layer 130, at least two of the regions 132 are formed on the one first conductive layers 120 (the anode electrode 122). Moreover, at a part of the first conductive layers 120 (the anode electrode 122) where the first conductive layer 120 (the anode electrode 122) and the third conductive layer 150 (the cathode electrode 151) overlap in a plan view, it is preferable that as many regions 132 as possible are formed, for example, at least ten of the regions 132 are preferably formed.

In the case where one of the regions 132 of the second conductive layer 130 is formed extending between the first conductive layer 120 and the section where the adjacent first gap 121 is provided, when current is supplied, the entire section where the second conductive layer 130 is formed comes to be the light-emitting region. As the regions 132 of the second conductive layer 130, which are formed at which the first gaps 121 are provided, are not designed as a light-emitting area, these regions 132 may preferably be small. Thus, when the second conductive layer 130 is formed of many regions 132, the areas of the respective regions 132 gets small, so even when one of the regions 132 of the second conductive layer 130 is formed extending over the first conductive layer 120 and the section where the adjacent first gaps 121 are provided, large-scale bleeding may not be caused.

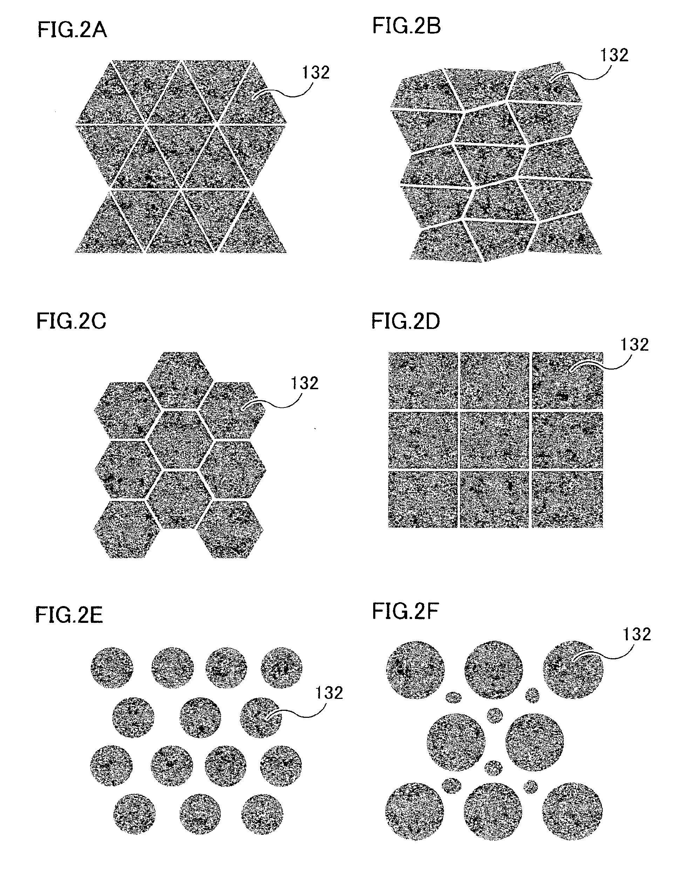

FIG. 2A to 2F are diagrams for illustrating specific examples of shapes of plural regions 132 which form a second conductive layer 130 and are isolated from each other.

In FIG. 2A, the second conductive layer 130 is formed of the regions 132 which are regular triangular shape with the same size. In FIG. 2B, the second conductive layer 130 is formed of the regions 132 which are quadrilateral shape with the same size. In FIG. 2C, the second conductive layer 130 is formed of the regions 132 which are regular hexagonal shape with the same size. In FIG. 2D, the second conductive layer 130 is formed of the regions 132 which are rectangular shape with the same size. In FIG. 2E, the second conductive layer 130 is formed of the regions 132 which are circular shape with the same size. In FIG. 2F, the second conductive layer 130 is formed of the regions 132 which have two kinds of circular shapes with different size.

In the present exemplary embodiment, various shapes are adopted as the shape of one of the regions 132 of the second conductive layer 130, for example, polygonal shape, concave polygonal shape, circular shape, ellipsoidal shape, shape with rounded corners, and the like. The second conductive layer 130 may be formed by using the plural regions 132 which all have the same shape, or by combining the plural regions 132 which have different shapes. Moreover, the plural regions 132 may be periodically arranged, or may be non-periodically arranged. Further, the second conductive layer 130 may be formed by using the plural regions 132 with the same size, or by combining the plural regions 132 with different size.

It is preferable that the second conductive layer 130 formed on the first conductive layer 120 may have a large total area of the respective regions 132 of the second conductive layer 130 on the first conductive layer 120, in other words, the total area of the portion of the first conductive layer 120 at which the second gaps 131 (refer to FIG. 1) is provided is small.

Thus, the plural regions 132 are preferably combined so that the total area of the respective regions 132 of the second conductive layer 130 on the first conductive layer 120 is large, as long as the regions 132 of the second conductive layer 130 formed on the first conductive layer 120, and the regions 132 of the second conductive layer 130 formed on the substrate 110 at which the first gaps 121 are provided, or the regions 132 of another second conductive layer 130 formed on the other first conductive layer 120 adjacent to the first conductive layer 120 are insulated.

As to the above-mentioned insulation of the respective regions 132 of the second conductive layer 130, the regions 132 of the second conductive layer 130 may completely be isolated from each other. Even when a part of among the regions 132 is connected, by forming width of the part to be narrow or forming thickness of the part to be thin, the regions 132 are in a substantially insulation state.

As shown in FIGS. 2A to 2F, the second conductive layer 130 is formed of the plural regions 132 which are isolated from each other by the second gaps 131. The width of the second gaps 131 is not particularly limited, however, in the present exemplary embodiment, in the range of 10 nm to 200 µm, preferably 100 nm to 100 µm. Note that, the area of the respective regions 132 is not particularly limited, however preferably smaller than the area of the first conductive layer 120.

In the present exemplary embodiment, for making the plural regions 132 of the second conductive layer 130, which are formed isolated from each other, shown so that the light-emitting regions are surface-emitting, it is more preferable as the second gaps 131 which are the intervals between the regions 132 are narrower. On the other hand, the second gaps 131 are preferably wide for maintaining insulation properties between the first conductive layers 120.

The regions 132 of the second conductive layer 130 are preferably smaller than the first gaps 121 which isolate the first conductive layer 120. The areas of the regions 132 are preferably small for reducing bleedings, cross talks, and short circuits which are caused on outer edge portions of the light-emitting regions. On the other hand, the areas of the regions 132 are preferably large for easily performing a patterning with inexpensive methods.

The areas of one region 132 of the second conductive layer 130 are not particularly limited. In the present exemplary embodiment, in a plan view, ratio of the plural regions 132 of the second conductive layer 130 occupying the anode electrode 122 of the first conductive layer 120 is in the range of 50% to 99%, and preferably 60% to 95%. When the ratio of the plural regions 132 occupying the anode electrode 122 of the first conductive layer 120 is too small, the light-emitting area becomes smaller than a designed value and brightness tends to decrease. On the other hand, when the ratio of the plural regions 132 occupying the first conductive layer 120 is too large, width of the second gaps 131 becomes narrow, and the difficulties in production, electrical connection among the plural regions 132, and the like easily tend to be caused.

The respective of the plural regions 132 of the second conductive layer 130 are formed so as not to extend over two of the first conductive layers 120 which are formed spaced by the first gap 121. The respective sizes of the plural regions 132 are not particularly limited. In the present exemplary embodiment, the respective regions 132 preferably have the smaller width than the minimum width of the first gaps 121 in the sections corresponding to the first gaps 121 dividing the first conductive layer 120. In other words, in the case where at least a part of one of the regions 132 is formed in the section corresponding to the first gap 121 spacing between the first conductive layers 120, the width of the region 132 in the direction in which the first gap 121 is the minimum is preferably smaller than the minimum width of the first gap 121.

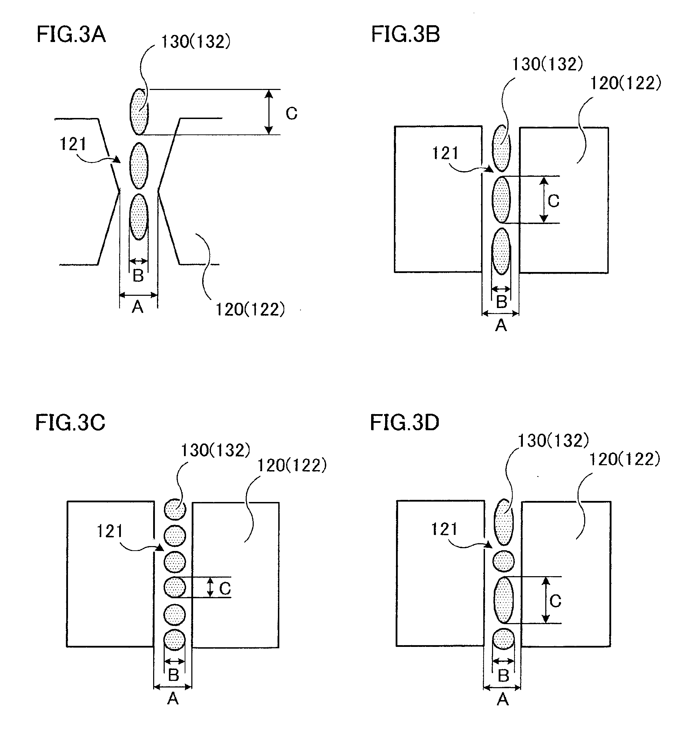

FIGS. 3A to 3D are diagrams for explaining a relationship between a first gap 121 and a size of the plural regions 132 of the second conductive layer 130. Here, in FIG. 3A to FIG. 3D, width B of the region 132 in the direction in which the first gap 121 is the minimum and the maximum width C of the region 132 are shown. That is, the maximum width C is the maximum value of the length between two lines which contact the region 132 in parallel to each other and are spaced by the region 132.

FIG. 3A is a diagram for explaining the case where the length of the first gap 121 spacing the first conductive layers 120 is not constant. In the present exemplary embodiment, in the direction in which the length of the first gap 121 is the minimum value (the minimum width A), the width B of the region 132 is formed so as to be smaller than the minimum width A of the first gap 121.

FIGS. 3B to 3D are diagrams for explaining the case where the length of the first gap 121 spacing the first conductive layers 120 is constant. In this case, the length of the first gap 121 is the same as the minimum width A. FIG. 3B illustrates that the width B of the region 132 of the second conductive layer 130 in the direction in which the first gap 121 is the minimum is shorter, and the maximum width C thereof is longer compared to the minimum width A of the first gap 121. FIG. 3C illustrates that both of the width B of the region 132 of the second conductive layer 130 (in the direction in which the first gap 121 is the minimum) and the width C thereof are shorter than the minimum width A of the first gap 121. FIG. 3D illustrates that the regions 132 of the second conductive layer 130 in FIG. 3B and the regions 132 of the second conductive layer 130 in FIG. 3C are intermingled.

As shown in FIGS. 3A to 3D, width of the region 132 of the second conductive layer 130 is not particularly limited, however the respective regions 132 preferably have the narrower width (the width B of the region 132) compared to the minimum width A of the first gap 121in the same direction of the minimum width A of the first gaps 121.

As the respective regions 132 have the smaller width (the width B of the region 132) than the first gaps 121 spacing the first conductive layers 120, one of the regions 132 may be formed only on the sections corresponding to the first gaps 121 on the substrate 110, or may be formed so as to contact only any one of the first conductive layers 120 (the anode electrode 122). At this time, the regions 132 are not formed extending either between the plural first conductive layers 120 (the anode electrodes 122) or between the first conductive layer 120 (the anode electrode 122) and the cathode terminal 123.

Thereby, for example, in the case where one of the first conductive layers 120 (the anode electrode 122) is applied voltages, voltage is applied to only the plural regions 132 (including the ones in which only a part thereof is formed on the first conductive layer 120) of the second conductive layer 130, which are formed on the first conductive layer 120 (the anode electrode 122) to which voltage is applied. On the other hand, voltage is not applied to the regions 132 of the second conductive layer 130 other than these regions 132.

Therefore, even when the first conductive layers 120 (the anode electrode 122) and the plural regions 132 of the second conductive layer 130 are formed on the entire region of the substrate 110, short circuits and cross talks do not occur. Moreover, the length of the plural regions 132 of the second conductive layer 130, to which voltages are applied, extending to the section of the first gap 121 spacing the first conductive layer 120 is not more than the maximum width C of the plural regions 132. Thus, bleeding can be reduced by minimizing the size of the plural regions 132 of the second conductive layer 130.

Moreover, in the present exemplary embodiment, it is preferable that the maximum width C of the respective regions 132 of the second conductive layer 130 is smaller than the first gaps 121 spacing the plural first conductive layers 120 (the anode electrodes 122).

In the case where the regions 132 are formed on the sections corresponding to the first gaps 121 of the substrate 110, when the maximum width C of the respective regions 132 of the second conductive layer 130 is smaller than the first gaps 121 of the first conductive layers 120 (the anode electrodes 122), the region 132 does not extend to two of the first conductive layers 120 (the anode electrodes 122) adjacent to each other, even when the shape of the regions 132 are formed to be shifted in the rotational direction. Therefore, in the case of forming the plural regions 132 of the second conductive layer 130, the second conductive layer 130 which includes the plural regions isolated from each other may be formed without previously setting angle or direction for arranging the substrate 110.

### (Organic compound layer 140)

The organic compound layer 140 may be configured with a single layer structure which has one light-emitting layer 141, or with the multi-lamination layer structure which has more than two layers. Specifically, the light-emitting layer 141 is formed between the first conductive layer 120 and the third conductive layer 150 or between the second conductive layer 130 and the third conductive layer 150. Moreover, the organic compound layer 140 may be laminated with a layer which includes one or more than two layers selected from a charge moving layer, a charge blocking layer other than the light-emitting layer 141. Further, a charge-injection layer may be included between the light-emitting layer 141 and the third conductive layer 150, and between the light-emitting layer 141 and the first conductive layer 120 or between the light-emitting layer 141 and the second conductive layer 130.

The light-emitting layer 140 is a layer having a light-emitting material which emits the light by applying voltage to the first conductive layer 120 and the third conductive layer 150 and being applied current to. And in the light-emitting layer 141, holes injected from the anode electrode 122 and electrons injected from the cathode electrode 151 are recombined, and light emission occurs.

The thickness of the organic compound layer 140 is not particularly limited, however, for example, preferably in the range of 0.005 µm to 1 µm, more preferably 0.01 µm to 0.5 µm, further preferably 0.03 µm to 0.2 µm.

As a material constituting the light-emitting layer 141, either a luminescent organic material or a luminescent inorganic material may be used. As a luminescent organic material, either a non-polymeric compound or a polymeric compound may be used. Furthermore, as a luminescent organic material, a phosphorescent organic compound and a metal complex are preferable. Among the metal complexes, there exist ones that show phosphorescence, and such metal complexes are also preferably used.

In the present exemplary embodiment, as a metal complex of the luminescent organic material in particular, it is exceptionally desirable to use cyclometalated complexes in terms of improving light emission efficiency. As the cyclometalated complexes, complexes of Ir, Pd, Pt and the like including ligands such as 2-phenylpyridine derivatives, 7, 8-benzoquinoline derivatives, 2-(2-thienyl)pyridine derivatives, 2-(1-naphthyl)pyridine derivatives, 2-phenylquinoline derivatives are provided, and iridium (Ir) complexes are especially preferred.

The cyclometalated complexes may include ligands other than the ligands required to form the cyclometalated complexes. Note that the cyclometalated complexes are preferable in terms of improving light emission efficiency because compounds that emit light from triplet exciton are included therein.

As the polymeric molecular compound, specific examples include; poly-p-phenylenevinylene (PPV) derivatives such as MEH-PPV (poly[2-methoxy-5-(2-ethylhexyloxy)-1,4-phenylenevinylene]); polymer compounds of a π-conjugated system such as polyfluorene derivatives and polythiophene derivatives; polymers introducing low-molecular pigments and tetraphenyldiamine or triphenylamine to a main chain or a side chain and the like. Polymeric molecular compounds and non-polymeric molecular compounds can be used in combination.

The light-emitting layer 141 includes the light-emitting material and a host material, and the light-emitting material is dispersed in the host material in some cases. It is preferable that the host material has charge transporting properties, and it is also preferable that the host material is a hole-transporting compound or an electron-transporting compound.

The above organic compound layer 140 may include a hole-transporting layer to receive a hole from an electrode (the anode electrode 122) and transport the hole to the light-emitting layer 141. As the hole-transporting materials for forming the hole-transporting layer, publicly known materials can be used. Specific examples thereof include low molecular triphenylamine derivatives such as: TPD (N,N'-diphenyl-N,N'-bis(3-methylphenyl)-1,1'-biphenyl-4,4'diamine); α-NPD (4,4'-bis[N-(1-naphthyl)-N-phenylamino]biphenyl); and m-MTDATA (4,4',4"-tris(3-methylphenylphenylamino)triphenylamine); polyvinylcarbazole; and triphenylamine derivative-based high-molecular compound polymerized by introducing a polymerizable functional group. The above hole-transporting materials may be used solely or by mixing two or more, and may be used by laminating different hole-transporting materials. The thickness of the hole-transporting layer depends on the conductivity of the hole-transporting layer, and is not particularly limited, however, in the present exemplary embodiment, preferably in the range of 1 nm to 5 µm, more preferably 5 nm to 1 µm, further preferably 10 nm to 500 nm.

In the case where the conductivity of the hole-transporting layer is high, it is desirable that the plural regions 132 are performed a patterning as in the above second conductive layer 130 described above.

Further, the above organic compound layer 140 may include an electron transporting layer that receives an electron from the cathode electrode 151 and transports the electron to the light-emitting layer 141. The material which can be used for the electron transporting layer includes; quinolinic derivatives, oxiadiazole derivatives, perylene derivatives, pyridine derivatives, pyrimidine derivatives, quinoxaline derivatives, diphenylquinone derivatives, nitro displacement fluorene derivatives or the like.

More specifically, tris(8-quinolinolato)aluminium (abbreviated expression: Alq), bis(2-metho-8-quinolinolato)(4-phenylphenolato)aluminium, bis[2-(2-hydroxyphenyl)benzothiazolato]zinc, 2-(4-biphenylyl)-5-(4-tert-butylphenyl)-1,3,4-oxadiazol can be used.

Further, for the purpose of suppressing holes from passing through the light-emitting layer 141 and efficiently recombining holes and electrons in the light-emitting layer 141, a hole-block layer may be provided between the above electron transporting layer and the light-emitting layer 141. In order to form the above hole-block layer, publicly known materials such as a triazine derivative, an oxadiazole derivative, a phenanthroline derivative or the like may be used.

### (Third conductive layer 150)

As a material used for the cathode electrode 151 of the third conductive layer 150 is not particularly limited as long as the ones which have electronic conductivity. In the present exemplary embodiment, in the case where the light is extracted from the cathode electrode 151 side of the organic light-emitting element 10 (in the case where the surface of the cathode electrode 151 side is the light-extracting surface, that is, the light-emitting surface), it is preferable that a material which is transparent to the emitted light is used. On the other hand, in the case where it is not necessary to extract the light from the cathode electrode 151 side of the organic light-emitting element 10, it is not limited to the materials which are transparent to the emitted light, and an opaque material can be used. In the case where the third conductive layer 150 is used as the cathode electrode 151, the ones which have a low work function and are chemically stable are preferred. Specific example includes: Al; alloys of MgAg; alloys of alkali metals and Al such as AlLi; alloys of alkaline earth metals and Al such as AlCa or the like.

The thickness of the cathode electrode 151 is preferably in the range of 0.01 µm to 1 µm, and more preferably 0.05 µm to 0.5 µm.

The electron injection efficiency may be increased by providing the electron-injecting layer adjacent to the cathode electrode 151 to lower the barrier for the electron injection from the cathode electrode 151 into the electron transporting layer. The electron-injection layer is required to have a lower work function than the cathode electrode 151, and metal materials are preferably used. Specifically, for example, the material thereof includes alkali metals (Na, K, Rb and Cs), alkaline earth metals (Sr, Ba, Ca and Mg), rare earth metals (Pr, Sm, Eu and Yb), one selected from fluoride, chloride and oxide of these metals and mixture of two or more selected therefrom. The thickness of the electron-injecting layer is preferably in the range of 0.1 nm to 50 nm, more preferably 0.3 nm to 20 nm, and still more preferably 0.5 nm to 10 nm.

### (Second exemplary embodiment)

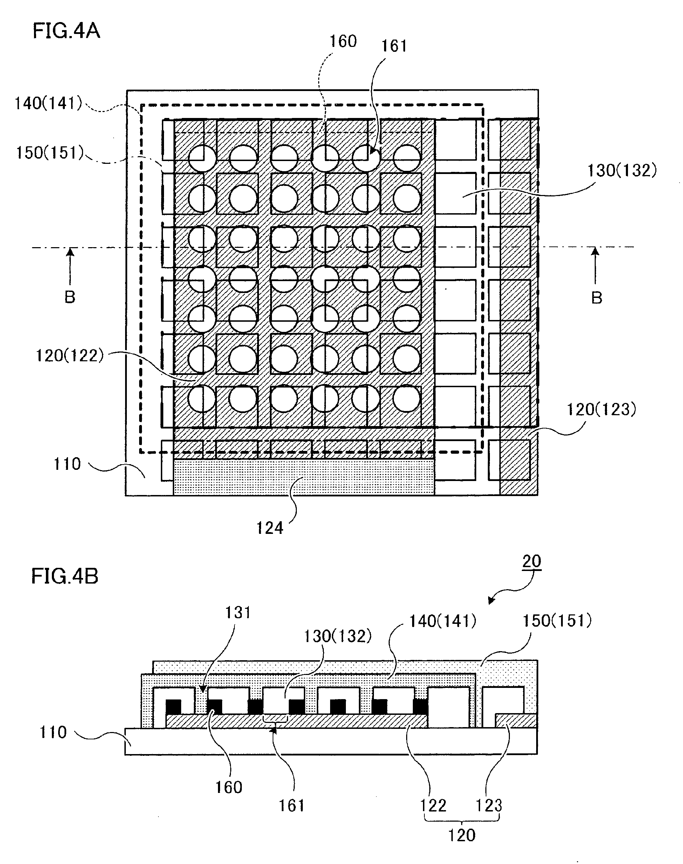

FIGS. 4A and 4B are schematic views for illustrating an example of an organic light-emitting element 20 to which the second exemplary embodiment is applied. The configurations in common with those in the first exemplary embodiment are appended to the same symbols and the detail explanations thereof are omitted. FIG. 4A is a planar schematic view of an example of the plural regions 132 of the second conductive layer 130 formed on one of the anode electrodes 122 of the first conductive layer 120, and FIG. 4B is a schematic view of B-B cross section.

Hereinafter, the organic light-emitting element 20 will be explained based on FIGS. 4A and 4B.

As shown in FIG. 4A and FIG. 4B, the organic light-emitting element 20 is formed of the substrate 110, the first conductive layer 120 which have the anode electrode 122 and the cathode terminal 123 formed to be provided with the first gaps 121 electrically isolating them from each other on the substrate 110, a dielectric layer 160 formed to be provided with plural passing-through portions 161 on the anode electrode 122, the second conductive layer 130 which is configured with the plural regions 132 electrically isolated from each other spaced by the second gaps 131 having a narrower width than the first gaps 121, the organic compound layer 140 which includes the light-emitting layer 141 and laminated above at least one of the first conductive layers 120, the third conductive layer 150 which is formed on at least the organic compound layer 140, in this order.

Note that, as shown in FIG. 4A, one edge of the anode electrode 122 of the first conductive layer 120 is formed toward the edge portion of the substrate 110, and a portion formed on this edge portion is the anode terminal 124.

In the present exemplary embodiment, in the cathode terminal 123 of the organic light-emitting element 20, the third conductive layer 150 (the cathode electrode 151) is, directly or through the second conductive layer 130, contacts the first conductive layer 120 (the cathode terminal 123). The second conductive layer 130 can be conducted by contacting the surface of the anode electrode 122 exposed inside the passing-through portion 161 of the dielectric layer 160. Therefore, for uniform light-emission of the entire region of the light-emitting region without unevenness of brightness, the plural regions 132 of the second conductive layer 130 formed on the anode electrode 122 of the light-emitting region preferably respectively contact the first conductive layer 120 (the anode electrode 122) through at least one of the passing-through portion 161.

In the present exemplary embodiment, note that, the passing-through portion 161 that passes through the dielectric layer 160 may include a passing-through hole connected with a passing-through portion 161 or a bored portion (not shown in the figure) of the first conductive layer 120 (the anode electrode 122) under the dielectric layer 160. Moreover, the passing-through portion 161 may pass through the first conductive layer 120 and include a passing-through hole connected with the bored portion where the substrate 110 is bored. Here, the bored portion is a hole with smaller depth of the concave portion than the thickness of the applicable layer and forms a concave portion on an applicable layer. In this case, the second conductive layer 130 contacts the first conductive layer 120 (the anode electrode 122) through the passing-through hole or the passing-through portion 161.

### (Relationship between the position of the passing-through portion 161 and the second conductive layer 130)

In the present exemplary embodiment, the second conductive layer 130 contacts the anode electrode 122 at least inside the passing-through portion 161, and the second conductive layer 130 which contacts the anode electrode 122 and is applied voltages can be conducted. At this time, the passing-through portion 161 may be or may not be completely included inside the region 132.

In the case where the plural passing-through portions 161 of the dielectric layer 160 are formed on one of the first conductive layers 120 (the anode electrodes 122), one of the regions 132 of the second conductive layer 130 may contact these plural passing-through portions 161.

On applying voltage between the first conductive layer 120 (the anode electrode 122) and the third conductive layer 150 (the cathode electrode 151) of the light-emitting element 20, the light-emitting layer 141 located therebetween emits light. In the case of the structure shown in FIGS. 4A and 4B, when the conductivity of the second conductive layer 130 is high, the second conductive layer 130 functions as an electrode. As a result, the light-emitting layer 141, which is provided between the region 132 of the second conductive layer 130 formed on the first conductive layer 120 (the anode electrode 122) to which voltages are applied and the light-emitting layer 141 of the third conductive layer 150 (the cathode electrode 151), may emit the light.

Note that, in the structure like the organic light-emitting element 20 in the present exemplary embodiment, the second conductive layer 130 may be the hole-injection layer or may be the second anode electrode. Therefore, as mentioned above, the materials used as an electrode, metals such as nickel and metal carbide, or the like may be used other than the materials used for the hole-injection layer.

A plane shape and a sectional shape of the passing-through portion 161 of the dielectric layer 160 formed on the first conductive layer 120 (the anode electrode 122) may be arbitrary shapes. For example, a circular shape or a polygonal shape may be adopted. Moreover, the maximum width of the passing-through portion 161 is preferably not more than 10 µm. Here, the maximum width of the passing-through portion 161 is a diameter of the minimum circle which includes the planar shape in the interface of the first conductive layer 120 and the passing-through portion 161 of the dielectric layer 160.

In the present exemplary embodiment, the passing-through portion 161 is preferably formed 10² to 10⁸ per 1 mm square at the portion where the dielectric layer 160 is formed. When the number of the passing-through portion 161 is too small, the contact resistance of the first conductive layer 120 and the second conductive layer 130 tends to increase, since the first conductive layer 120 and the second conductive layer 130 contact each other only inside the passing-through portion 161. Moreover, the number of the passing-through portion 161 is too large, overlap of the each of passing-through portions 161 and production of the passing-through portions 161 tend to be difficult, since the intervals of the passing-through portions 161 are too narrow.

The dielectric layer 160 is provided between the anode electrode 122 of the first conductive layer 120 and the third conductive layer 150 (the cathode electrode 151) for spacing and isolating the anode electrode 122 and the cathode electrode 151 from each other with a predetermined intervals. Therefore, the dielectric layer 160 is necessarily configured with a high resistance rate material, and is required to have the electrical resistance rate of 10⁸ Ωcm or more, preferably 10¹² Ωcm or more. Specific examples of the material include: metal nitrides such as silicon nitride, boron nitride and aluminum nitride; metal oxides such as silicon oxide (silicon dioxide) and aluminum oxide. In addition, polymer compounds such as polyimide, polyvinylidene fluoride and parylene can be used.

It is preferable that the thickness of the dielectric layer 160 does not exceed 1 µm for suppressing the entire thickness of the organic light-emitting element 20. Since the voltages required for light-emission is the lower when the interval between the anode electrode 122 and the cathode electrode 151 is the narrower, the dielectric layer 160 is preferably thin also in this term. However, when the dielectric layer 160 is too thin, dielectric strength of the voltages for driving the organic light-emitting element 20 becomes possibly insufficient. A thickness of the dielectric layer 160 which satisfies the above requirement is preferably in the range of 10 nm to 500 nm, more preferably 50 nm to 200 nm.

### (Third exemplary embodiment)

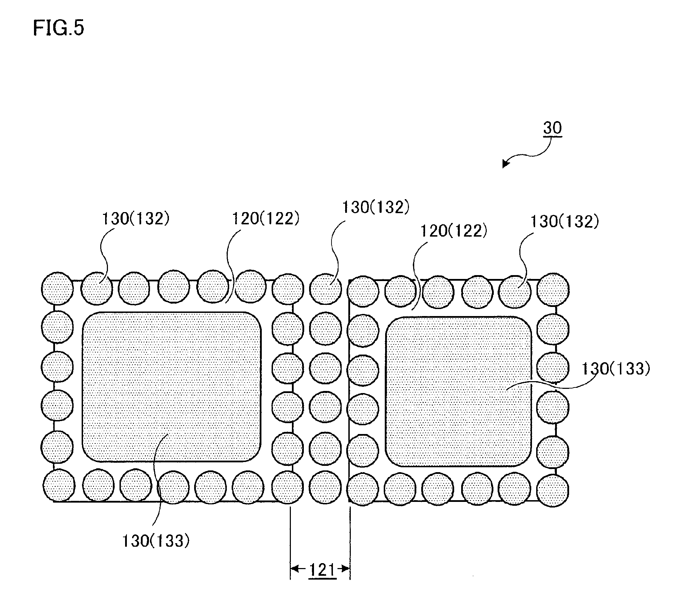

FIG. 5 is a schematic view for illustrating a specific example of an organic light-emitting element 30 to which the third exemplary embodiment is applied. The configurations in common with those in the first exemplary embodiment are appended to the same symbols and the detail explanations thereof are omitted.

The organic light-emitting element 30 shown in FIG. 5 is provided with plural first conductive layers 120 which are formed so as to be electrically insulated from each other and be spaced by first gaps 121 on the substrate (not shown in the figure), and the second conductive layer 130 which is configured with plural regions 132, 133 formed so as to be isolated from each other on sections corresponding to the top of the first conductive layer 120 and the first gaps 121. Note that, the first conductive layer 120 configures the anode electrode 122 of the organic light-emitting element 30.

As shown in FIG. 5, the second conductive layer 130 includes regions 132 which are formed at the periphery portion of the first conductive layer 120, and the regions 133 which are formed at the center portions of the first conductive layers 120. Here, the periphery portion of the first conductive layer 120 is all the periphery parts of the first conductive layer 120 where a distance (length) from an outer circumference to the inside of the first conductive layer 120 is not more than a distance (length) of the first gap 121.

In the present exemplary embodiment, width of the regions 132 formed at the periphery portion of the first conductive layer 120 is formed so as to be smaller than the first gaps 121 spacing the first conductive layer 120. Moreover, width of the regions 133 formed at the center portion of the first conductive layer 120 is formed so as to be larger than the first gaps 121.

Therefore, in the periphery portion of the first conductive layer 120 and sections corresponding to the first gaps 121, width of the plural regions 132 of the second conductive layer 130 is formed so as to be smaller than width of the first gaps 121, thus, when the second conductive layer 130 (the regions 132 and the regions 133) is formed, highly accurate position control is not necessary. Moreover, any one of the regions 132 of the second conductive layer 130 does not extend over between the anode electrodes 122 of the plural first conductive layer 120 and between the anode electrode 122 and the cathode terminal 123. Therefore, short circuits or cross talks can be prevented.

### <Method of producing an organic light-emitting element>

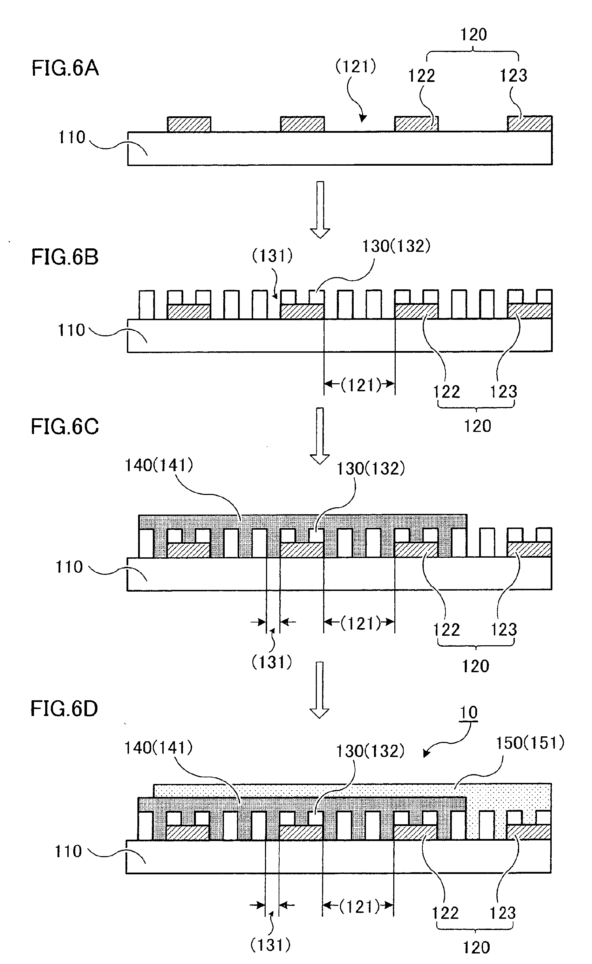

FIGS. 6A to 6D are diagrams for illustrating a specific example of a method of producing the organic light-emitting element 10. Here, it will be explained with an example of the case of the organic light-emitting layer 10 explained in FIG. 1. Note that, the configurations in common with those in the first exemplary embodiment are appended to the same symbols and the detail explanations thereof are omitted.

In the present exemplary embodiment, the organic light-emitting layer 10 is manufactured by a process (first conductive layer forming process) in which the plural first conductive layers 120 which are electrically isolated from each other and formed spaced by the first gaps 121 are formed on the substrate 110, a process (second conductive layer forming process) in which the first conductive layer 120 and the sections corresponding to the first gaps 121 of the substrate 110 are covered and non-patterned conductive layers different from the first conductive layers 120 are formed, further the non-patterned conductive layer is performed patterning, thereby, the second conductive layers 130, which are formed to include the plural regions 132 isolated from each other, is formed, a process (organic compound layer forming process) in which the organic compound layer 140 including the light-emitting layer 141 is formed above at least one of the plural first conductive layers 120 while contacting the second conductive layer 130, and a process (third conductive layer forming process) in which the third conductive layer 150 is formed on the organic compound layers 140.

In another exemplary embodiment, the organic light-emitting layer 10 is manufactured by a process (first conductive layer forming process) in which the plural first conductive layers 120, which are electrically isolated from each other formed spaced by the first gaps 121, are formed, a process (second conductive layer forming process) in which the first conductive layer 120 and the sections corresponding to the first gaps 121 of the substrate 110 are covered and patterned conductive layers different from the first conductive layers 120 are formed, thereby, the second conductive layers 130 which includes the plural regions 132 isolated from each other, a process (organic compound layer forming process) in which the organic compound layer 140 including the light-emitting layer 141 is formed above at least one of the plural first conductive layers 120 while contacting the second conductive layer 130, and a process (third conductive layer forming process) in which the third conductive layer 150 is formed on the organic compound layers 140.

Hereinafter, the respective processes will be explained.

### (First conductive layer forming process)

First, as shown in FIG. 6A, the anode electrodes 122 and the cathode terminals 123 which are the first conductive layers 120 are formed on the substrate 110. For forming these layers, a resistance heating deposition method; an electron beam deposition method; a sputtering method; an ion plating method; and a Chemical Vapor Deposition (CVD) method or the like can be used. In the case where the first conductive layers 120 are formed from metal particles such as silver, particles such as copper iodide, carbon black, conductive particles of metallic oxides, micronized conductive polymers, or the like, the first conductive layers 120 can be formed by dispersing the above material in an applicable binder resin solution and applying onto the substrate 110. In this case, by performing a heating treatment after forming-film by using a method such as a spin coating method; a dip coating method; an ink-jet printing method; a printing method; a spray-coating method; and a dispenser-printing method and the like, the first conductive layers 120 can be formed.

### (Second conductive layer forming process)

Next, as shown in FIG. 6B, the second conductive layers 130 are formed on the first conductive layers 120 and the sections corresponding to the first gaps 121 spacing the first conductive layers 120 of the substrate 110. Film-forming method of the second conductive layers 130 is not especially limited, and general methods can be used. For example, in the case of film-forming by use of the organic compounds, using a resistance heating deposition method or a coating method is preferable. For film-forming of layers including molecular organic compounds, particularly a coating method is preferably used. Specific example of coating method include: a spin coating method; a dip coating method; an ink-jet printing method; a printing method; a spray-coating method; and a dispenser-printing method or the like. As a film-forming method for a layer including oxides and metals, specific examples include: a resistance heating deposition method; an electron beam deposition method; a sputtering method; an ion plating method; and a CVD method. In this case, especially vacuum deposition method or a sputtering method is preferably used.

A method of performing a patterning of the second conductive layer 130 on the plural regions 132 is not especially limited, and general methods can be used. For example, a method in which a patterning is performed with the above method so that the first conductive layers 120 and the entire surface of the sections corresponding to the first gaps 121 of the substrate 110 are covered after forming the non-patterned conductive layers by using publicly known hole-injecting material, and a method in which a patterning is performed when the film-forming is performed by using the hole-injecting material as well are exemplified.

In the case of a method of performing a patterning after forming the non-patterned conductive layer, specific example of performing a patterning includes: removal by a solvent used for forming the non-patterned conductive layer; removal by adhesive, laser ablation, etching or the like.

Further, in the case of performing a patterning at the time of film-forming, specific example, for dividing the second conductive layer 130 into the plural regions 132, includes: a method in which protective films are previously formed on the sections corresponding to the second gaps 131 spacing the plural regions 132, and the protective films are removed after the formation of the second conductive layer 130; a method of using masks in a vacuum deposition or in a sputtering method or the like. In a coating method, an ink-jet printing method or a printing method can be used. In a coating method, in particular the substrate 110 or the first conductive layer 120 may be performed a surface treatment for facilitating a patterning of the plural regions 132.

The dielectric layers may be formed between the first conductive layers 120 adjacent to each other for insulating between the first conductive layers 120 which have the plural anode electrodes 122. For example, the dielectric layers may be formed between the first conductive layers 120 having stripe shape. In this case, the second conductive layers 130 are formed by patterning the plural regions 132 on the first conductive layers 120, the substrates 110, and the above-mentioned dielectric layers. The plural regions 132 of the second conductive layers 130 may have one of the regions 132 which is formed on not less than two places selected from the first conductive layers 120, or the substrates 110 and the dielectric layers, or may be formed only on the substrate 110, only on the first conductive layers 120, or only on the dielectric layers. Since the respective plural regions 132 of the second conductive layers 130 are formed spaced by the second gaps 131 narrower than the first gaps 121 electrically isolating the first conductive layers 120 from each other, in the case of applying current to one of the first conductive layers 120, the other first conductive layers 120 which are adjacent to the first conductive layer 120 are not applied voltages, and cross talks do not occur.

### (Organic compound layer forming process)

Next, as shown in FIG. 6C, the organic compound layer 140 which contacts the second conductive layers 130 and includes the light-emitting layer 141 is formed above at least one of the first conductive layers 120. In the case of forming the organic compound layers 140, a method such as the methods explained in the above-mentioned second conductive layers forming process can be used. In the present exemplary embodiment, for the film-forming of the respective layers included in the organic compound layer 140, a resistance heating deposition method or a coating method is preferred, and for the film-forming of the layers including polymer organic compounds, especially a coating method is preferred. In the case of performing a film-forming by a coating method, the applicable material constituting the layers is coated with a coating solution dissolved or dispersed in the predetermined solvent such as organic solvent, water and the like. For performing a coating, a spin coating method, a dip coating method, an ink-jet printing method, a printing method, a spray-coating method, and a dispenser-printing method or the like may be used. After the coating, the intended layers are formed by performing a heating or vacuuming and drying the coating solution.

### (Third conductive layer forming process)

Moreover, as shown in FIG. 6D, the third conductive layers 150 are formed on the organic compound layer 140 as the cathode portions 151. As a method for forming the third conductive layers, the same method as the above-mentioned method for forming the first conductive layers 120 is used.

In the present exemplary embodiment, a protective layer or a protective cover (not shown in the figure) for stably using the light-emitting element 10 for long periods and protecting the light-emitting element 10 from outside may be mounted after the sequence of the processes. As the protective layer, polymer compounds, metal oxides, metal fluorides, metal borides, silicon nitrides and silicon oxides may be used. A lamination thereof may also be used. As the protective cover, glass plates, plastic plates with a surface treated with low hydraulic permeability, or metals may be used. The protective cover may preferably be bonded to the substrate 110 by using a thermosetting resin or a photo-curable resin to be sealed. At this time, spacers may be used so that predetermined spaces are maintained, thus the prevention of scratches on the organic light-emitting element 10 is facilitated. Filling the spaces with inert gases such as nitrogen, argon and helium prevents the oxidation of the cathode electrode 151 on the upper side. Especially, in a case of using helium, high thermal conductivity thereof enables heat generated from the organic light-emitting element 10 upon application of voltage to be effectively transmitted to the protective cover. In addition, by putting desiccants such as barium oxide in the spaces, the organic light-emitting element 10 is easily prevented from being damaged by moisture absorbed in the sequence of the aforementioned manufacturing processes.

### (Other exemplary embodiment of the method of producing)

In the manufacture of the organic light-emitting element, a method of production by polyhedral cutting is generally used. In this method, the respective organic light-emitting elements are acquired by cutting the substrate after the production of the plural light-emitting elements on one piece of large-type substrate.

In this method as well as the above-mentioned manufacturing method of the organic light-emitting elements 10, not less than two of the light-emitting devices including the first conductive layers 120 which configure the light-emitting elements on the same substrate 110, the second conductive layers 130 of the plural regions 132 which are formed spaced by the second gaps 131, the organic compound layers 140, and the third conductive layers 150 are arranged to be formed.

Next, the substrate 110 is cut with respect to each light-emitting device after forming the third conductive layers 150. A method for cutting is not especially limited and general methods are provided. Specific example includes: a method of directly cutting the object to be cut with a blade by use of such as a dicer and a cutter; a method of dividing with pressing force onto a precut portion after incising a surface of the object to be cut with a scriber; a method of cutting with laser or the like. Moreover, as a cutting method, a method of using a diamond cutter or laser in the case where the material to be cut is glass, a method of using cutting blade or punching blade in the case where the material to be cut is plastic bay be selected depending on the cases.

At this case, as explained in the manufacturing processes of the organic light-emitting element 10, the protective layer or the protective cover is preferably mounted to be sealed before cutting with respect to each light-emitting device after forming the organic light-emitting elements.

In the present exemplary embodiment, the prevention of short circuits, cross talks, and bleedings in the respective organic light-emitting elements is facilitated, because the second conductive layers 130 are divided into the plural regions 132 by the second gaps 131.

Moreover, even when the second conductive layers 130 are formed on the entire substrate 110, by forming the plural regions 132 with the second gaps 131, the terminals are insulated even when the second conductive layers 130 are formed on the anode electrodes 122, or the anode terminals 124 and the cathode terminals 123, thereby short circuits and cross talks may not be caused.

Therefore, the second conductive layers 130 which have no problems of cross talks and bleedings on the substrate 110 with a large area is easily formed, and productivity may significantly be improved because manufacture by cutting the respective units is facilitated after forming plural display units and illumination units on one substrate 110.

### Example

Hereinafter, the present invention will be described further in detail with reference to examples. However, the present invention is not limited to the following examples as long as the scope of the gist thereof is not exceeded.

### [Preparation of light-emitting material solution]

### (Synthesizing of a phosphorescent light-emitting polymer compound)

A phosphorescent light-emitting polymer compound (A) was prepared in accordance with the method disclosed in the paragraph [0077] of International Publication No. WO2010-016512.

In other words, the following compounds expressed by the chemical formulas E-2 (iridium complex having a polymerizing substituent), E-54 (hole transporting compound) and E-66 (electron transporting compound) were dissolved in dehydrated toluene with the ratio (mass ratio) of E-2:E-54:E-66 = 1:4:5, and V-601 (manufactured by Wako Pure Chemical Industries, Ltd.) as a polymeric initiator was further dissolved therein.

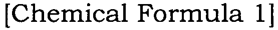

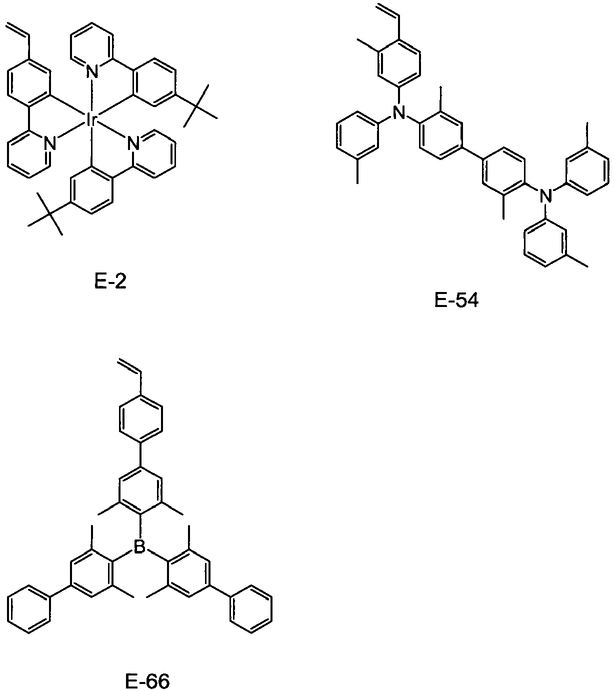

Next, after performing a freeze pumping operation on the above toluene solution, vacuum seal was performed, and the resultant solution was stirred for 100 hours at 70 degrees C for polymerization reaction. After the reaction, the reaction solution was delivered by drops into acetone to cause deposition, and then reprecipitation purification with dehydrated toluene-acetone was repeated three times to purify the phosphorescent light-emitting polymer compound (A). The weight-average molecular weight of polymer compound (A) was 52000, and molar ratio of each repeating unit was k : m : n = 6 : 42 : 52.

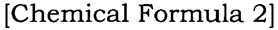

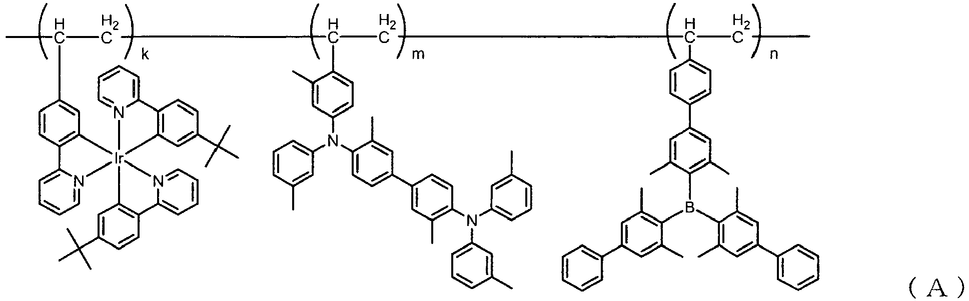

A light-emitting material solution (hereinafter, also referred to as "solution A") was prepared by dissolving 3 parts by weight of the light-emitting polymer compound prepared (A) in 97 parts by weight of toluene.

### [Preparation of organic light-emitting element]

### (Example 1)

With an operation below, the organic light-emitting element 10 shown in FIG. 1 is produced.

First, as the substrate 110, a glass substrate made of fused quartz (25 mm per side, a thickness of 1 mm) was used. A thin film (ITO film) of indium tin oxide (ITO) of 150 nm in thickness as the first conductive layer 120 was formed with a sputtering device (E-401s manufactured by Canon ANELVA Corporation). Resists OFPR800 and PMER6030 were coated on the ITO film formed on the glass substrate, and a resist film was formed by a patterning.

A prebake was performed to the resist for a predetermined time after application, then the respective resists were exposed in the applicable range, and were performed a patterning of the resist film for an applicable developing time. After the patterning of the resist film, post-bake for a predetermined time and etching were subsequently performed. As an etching solution, solution of hydrochloric acid: ferric chloride : H₂O (1 : 1.2 : 1) at 50 degrees C was used. By diluting the solution with H₂O, it is possible to stabilize etching time. Further, 30 seconds were added to a just etching time in which the substrate 110 is exposed by removal of ITO film for forming the tapered surface to be mostly flat and clear.

As a result, the first conductive layers 120 were patterned on the substrate 110, and three of the stripe-shape anode electrode 122 with 100 µm in width and three of the cathode terminals 123 were formed. At this time, the intervals of the first gaps 121 spacing each of the first conductive layers 120 was 120 µm both between any of the anode electrodes 122 and between any one of the anode electrodes 122 and any one of the cathode terminals 123.

Next, the second conductive layer 130 was formed by applying an aqueous suspension (1.5% by mass in content) of a mixture of poly(3,4)-ethylendioxythiophene (PEDOT) and polystyrene sulfonate (PSS) (PEDOT:PSS = 1:6 in mass ratio) to the substrate 110 and on the first conductive layer 120 by the spin coating method (spin rate: 3000 rpm), and being left under a nitrogen atmosphere at the temperature of 140°C for an hour to be dried.

Subsequently, the second gaps 131 (10 µm in width) of the second conductive layers 130 were regularly formed as shown in the figure by performing an ablation with Nd: YAG laser only on the second conductive layer 130 in order to form the second conductive layer 130 so that rectangular regions, which are smaller than the intervals (120 µm) of the first gaps 121 and have the width of 45 µm and the length of 80 µm, are formed spaced by the interval of 10 µm.

Note that, as another method of forming the second gaps 131 of the second conductive layer 130, for example, a method in which the portions where the second gaps 131 are formed are performed a wiping with urethane foam including mixed solvent of water and 1-propanol (2:1) is provided. Moreover, in the case of applying the second conductive layers 130 with an ink-jet printing method, it is preferable to perform a water repellent processing on the surface of the anode electrode 122 before the application so that the applied solution may not be spreading, though the above plural regions 132 can be formed at the time of application.

Next, the organic compound layers 140 including the light-emitting layer 141 were formed by applying xylene solution (solution A) of a polymer compound (A) to the above first conductive layer 120 and the second conductive layer 130 by the spin coating method (spin rate: 3000 rpm), and being left under a nitrogen atmosphere at the temperature of 210°C for an hour to be dried.

Subsequently, the organic light-emitting elements 10 are manufactured by forming films of sodium fluoride (4 nm) as a cathode buffer layer and aluminum (13 nm) as the third conductive layers 150 (the cathode electrodes 151) by an evaporation method in this order.

### (Example 2)

The organic light-emitting element 20 shown in FIGS. 4A and 4B was produced by the following operations. Here, the organic light-emitting element 20 was produced by the same processes as those in the first exemplary embodiment except that the respective of the anode electrodes 122 of the first conductive layer 120 and the cathode terminals 123 of the first conductive layers 120 were formed by using glass substrates with the size of 300 mm square and the thickness of 1 mm as the substrates 110, and the second conductive layers 130 were formed with molybdenum oxide, moreover, the dielectric layers 160 were formed.

As well as in the first exemplary embodiment, the first gaps 121 between the anode electrodes 122 and the cathode terminals 123 were formed so as to be 3 mm by performing a patterning of resist and an etching after forming the first conductive layer 120 on the substrate 110. After that, thin films of silicon dioxide (SiO₂) layer with 100 nm in thickness as the dielectric layer 160 were formed with a sputtering device (E-401s manufactured by Canon ANELVA Corporation).

Next, photoresists (AZ1500 manufactured by AZ Electronic Materials) with approximately 1 µm in thickness were formed on the dielectric layers 160 with a spin coating method. Subsequantly, on a quartz (3 mm in film thickness) as a substrate, a mask A corresponding to a pattern in which circles are arranged in a cubic lattice was produced, and exposure was performed in a reduction rate of 1/5 by use of a stepper exposure device (NSR-1505i6 manufactured by NIKON CORPORATION). Subsequently, development was executed with 1.2% aqueous solution of TMAH (tetramethyl ammonium hydroxide: (CH₃)₄NOH) for patterning the resist layer.

Next, by use of a reactive ion etching device (RIE-200iP manufactured by SAMCO Inc.), dry etching process was performed for patterning the silicon dioxide layer. As an etching condition, trifluoromethane (CHF₃) was used as a reactant gas, and the reaction was executed for 10 minutes under conditions of a pressure of 0.3Pa and output bias/ICP = 60/100 (W).

Then, the residue of the resist was removed by the resist removing solution, and the silicon dioxide layer was cleaned by showering pure water thereto, then dried by use of a spin dry device. As a result, the passing-through portions 161 with 2 µm in diameter were formed with density of 6 x 10⁴ /mm square spaced by intervals of 2 µm in a cubic lattice arrays.

Next, on the dielectric layers 160 on which formed the passing-through portions 161 were formed, thin films of molybdenum oxides with 70 nm in thickness were formed as the second conductive layers 130 by a vacuum deposition method. Subsequently, a photoresist (AZ1500 manufactured by AZ Electronic Materials) of approximately 1 µm in film thickness was formed by a spin coating method. Next, on a quartz (having a thickness of 3 mm) as a substrate, a mask B, which is a line patterning lined with width of 0.5 mm and spaced by 1 cm in pitch, was used to perform an ultraviolet exposure for the photoresist layers in a reduction rate of 1/5 by a stepper exposure device (NSR-1505i6 manufactured by NIKON CORPORATION). Further, the mask B was rotated with 90 degrees, and another ultraviolet exposure for the photoresist layers in respect with the same condition was performed. Then, development was executed with 1.2% aqueous solution of TMAH for patterning the resist layer into the square shape. Thereafter, heat at a temperature of 130°C was applied for 10 minutes (post-bake processing).

Subsequently, by use of a reactive ion etching device (RIE-200iP manufactured by SAMCO Inc.), a dry etching processing was performed with argon as a reactive gas. Then, by removing the residue of the resist by the resist removing solution, molybdenum oxide layers were acquired as the second conductive layers 130 in which the plural regions 132 divided by pitches of 2 mm in both X and Y axis directions are formed so that the second gaps 131 were 0.1 mm.

Next, as well as in the first exemplary embodiment, the organic compound layer 140 having the light-emitting layers 141 were formed by applying xylene solutions of polymer compound prepared (A) to the first conductive layers 120, the dielectric layers 160, and the second conductive layers 130 by the spin coating method (spin rate: 3000 rpm), and being left under a nitrogen atmosphere at the temperature of 210°C for an hour to be dried.

Subsequently, on the above organic compound layers 140, sodium fluorides (4 nm) were formed as the cathode buffer layers, then aluminums (130 nm) were formed as the third conductive layers 150 (the cathode electrodes 151) in this order by an evaporation method, thus, the organic light-emitting element 20 was formed.

### (Comparative example 1)

In the production of the organic light-emitting element 10 which is explained in the first exemplary embodiment, conductive layers configured with (PEDOT/PSS) were formed by applying aqueous suspension (1.5% by mass in content) of a mixture of poly(3,4)-ethylendioxythiophene (PEDOT) and polystyrene sulfonate (PSS) (PEDOT:PSS = 1:6 in mass ratio), which is used for the formation of the second conductive layers 130, to the substrates 110 and the first conductive layers 120 by the spin coating method (spin rate: 3000 rpm), and being left under a nitrogen atmosphere at the temperature of 140°C for an hour to be dried. Subsequently, only the second conductive layers 130 were performed an ablation with Nd:YAG laser. Specifically, the portion, which is 20 µm apart from the contour of the first electrode, was performed an ablation with 10 µm in line width. After that, as well as in the first exemplary embodiment, the organic compound layers 140, the cathode buffer layers, and the cathode electrodes 151 were formed in this order, and the organic light-emitting elements with a configuration in which only the cathode terminals 123 and the anode electrodes 122 were insulated were formed.

### (Comparative example 2)

In the production of the organic light-emitting elements 20 which is explained in the second exemplary embodiment, the molybdenum oxide layers as conductive layers were formed by forming the thin films of molybdenum oxide with 70 nm in thickness on the substrates 110, the first conductive layers 120, and the dielectric layers 160 by a vacuum deposition method used for the formation of the second conductive layers 130. At the time of forming the molybdenum oxide layers, the molybdenum oxide layers were formed only on the anode electrodes 122 by using masks corresponding to the shapes of the anode electrodes 122 of the first conductive layers 120. Then, the organic compound layers 140, the cathode electrode buffer layers, and the cathode electrodes 151 were formed in this order, and the organic light-emitting element with a configuration in which only the cathode terminals 123 and the anode electrodes 122 were insulated.

### (Evaluation of light-emitting property)

### (1) Number of defects

In the Examples 1, 2, the Comparative Examples 1 and 2, the organic light-emitting elements were respectively produced 100 for an assessment of the respective examples, and the number of the organic light-emitting elements were counted (unit: number of individuals), in which 1) occurrence of short circuits or 2) light-emitting areas different from the design value were observed.

Here, the light-emitting area different from the designed value is that (the surveyed light-emitting areas / the designed value of the light-emitting areas) is +-5% or more. As the number was smaller, the more organic light-emitting elements without problems of cross talks and bleedings were acquired. The result is shown in the table 1.

**[Table 1]**

| | Number of defects |
|---|---|
| Example 1 | 2 |
| Example 2 | 1 |
| Comparative Example 1 | 50 |
| Comparative Example 2 | 35 |

As the result shown in the table 1, in the case of the organic light-emitting elements 10, 20 that include the plural anode electrodes 122 which are electrically isolated from each other by the first gaps 121 of the substrates 110 and the plural regions 132 which are formed to be isolated from each other by the second gaps 131 on the anode electrodes 122 and on the sections corresponding to the first gaps 121 of the substrate 110, it can be seen that the number (the number of defects) of the organic light-emitting elements, in which 1) occurrence of short circuits and 2) light-emitting areas different from the designed value were observed, were hugely decreased compared to the case where the plural regions isolated from each other are not formed in the second conductive layers 130.

In the comparative example 1, it is difficult to perform an ablation with the constant distance of 20 µm on the periphery of the first conductive layers 120, and occurrence of short circuits and generation of elements having the light-emitting elements with small area or large area were generated. Moreover, in the comparative example 2, by shifting the position of a mask, generation of elements having the light-emitting elements with small area or large area were generated. In the Examples 1 and 2, elements almost having none of these defects were acquired in contrast to these cases.

### Reference Signs List

- 10,20: Organic light-emitting element
- 110: Substrate
- 120: First conductive layer
- 121: First gap
- 122: Anode electrode
- 123: Cathode terminal
- 124: Anode terminal
- 130: Second conductive layer
- 131: Second gap
- 132,133: Region
- 140: Organic compound layer
- 141: Light-emitting layer
- 150: Third conductive layer
- 151: Cathode electrode
- 160: Dielectric layer
- 161: Passing-through portion

## Claims

1. An organic light-emitting element comprising:
a substrate;
a plurality of first conductive layers that are formed spaced by gaps on the substrate and electrically isolated from each other;
a second conductive layer that includes a plurality of regions isolated from each other and are formed on the first conductive layers and on sections of the substrate at which the gaps are provided;
an organic compound layer that includes a light-emitting layer and is laminated on the plurality of regions of the second conductive layer formed on at least the first conductive layers; and
a third conductive layer that is formed on at least the organic compound layer, wherein
at least two regions of the second conducive layer are respectively formed on each of the first conductive layers at a light-emission region at which the first conductive layers and the third conductive layer overlap in a plan view, and
each of the regions of the second conductive layer contacts only any one of the first conductive layers or is electrically isolated from all of the first conductive layers.

2. The organic light-emitting element according to claim 1, wherein the plurality of regions of the second conductive layer are regions in which the plurality of regions with same or different shape or the plurality of regions with same or different area are regularly arranged.

3. The organic light-emitting element according to any one of claims 1 and 2, wherein a width of each of the regions of the second conductive layer is smaller than the minimum width of each of the gaps at a section corresponding to the gaps spacing the first conductive layers.

4. The organic light-emitting element according to any one of claims 1 to 3, wherein the maximum width of each of the regions of the second conductive layer is smaller than the minimum width of each of the gaps electrically isolating the first conductive layers from each other.

5. The organic light-emitting element according to any one of claims 1 to 4, wherein the second conductive layer is a layer in which the plurality of regions with same shape are regularly arranged in a plane of the second conductive layer.

6. The organic light-emitting element according to any one of claims 1 to 5, wherein at least ten of the regions of the second conductive layer are formed on each of the first conductive layers corresponding to sections at which the first conductive layers and the third conductive layer overlap in a plan view.

7. The organic light-emitting element according to any one of claims 1 to 6, wherein at least one of the first conductive layers is an anode electrode and the second conductive layer on the anode electrode is a hole-injection layer.

8. The organic light-emitting element according to any one of claims 1 to 6, wherein at least one of the first conductive layers contacts the third conductive layer or the second conductive layer on the first conductive layers contacts the third conductive layer.

9. The organic light-emitting element according to any one of claims 1 to 8, wherein a dielectric layer in which a plurality of passing-through portions are provided is formed in at least a part between the first conductive layers and the second conductive layer, and the second conductive layer contacts the first conductive layer in the passing-through portions of the dielectric layer.

10. The organic light-emitting element according to claim 9, wherein each of the passing-through portions of the dielectric layer has a circular or polygonal shape with the maximum width of not more than 10 µm in an arbitrary surface of the first conductive layer.

11. The organic light-emitting element according to any one of claims 9 and 10, wherein each of the passing-through portions of the dielectric layer is formed 10² to 10⁸ per 1 mm square in an arbitrary surface of the first conductive layers.

12. A method for producing an organic light-emitting element comprising:
a process in which a plurality of first conductive layers spaced by gaps and electrically isolated from each other are formed on a substrate;
a process in which a non-patterned conductive layer that is different from the first conductive layers and is formed on the first conductive layers and on sections of the substrate corresponding to the gaps;
a process in which the non-patterned conductive layer is patterned to form a second conductive layer including a plurality of regions isolated from each other on the first conductive layers and on sections of the substrate at which the gaps are provided;
a process in which an organic compound layer that contacts the second conductive layer and includes a light-emitting layer is formed above at least one of the first conductive layers; and
a process in which a third conductive layer is formed on the organic compound layer, wherein
at least two regions of the second conducive layer are respectively formed on each of the first conductive layers at a light-emission region at which the first conductive layers and the third conductive layer overlap in a plan view, and each of the regions of the second conductive layer contacts only any one of the first conductive layers or is electrically isolated from all of the first conductive layers.

13. A method for producing an organic light-emitting element comprising:
a process in which a plurality of first conductive layers spaced by gaps and electrically isolated from each other are formed on a substrate;
a process in which a second conductive layer that is patterned and includes a plurality of regions formed on the first conductive layers and on sections of the substrate corresponding to the gaps and isolated from each other;
a process in which an organic compound layer that contacts the second conductive layer and includes a light-emitting layer is formed above at least one of the plurality of the first conductive layers; and
a process in which a third conductive layer is formed on the organic compound layer.

14. The method for producing the organic light-emitting element according to claim 13, wherein at least two regions of the second conducive layer are respectively formed on each of the first conductive layers, and each of the regions contacts only any one of the first conductive layers or is electrically isolated from all of the first conductive layers.

15. The method for producing the organic light-emitting element according to claims 12 to 14 comprising: a process in which an organic light-emitting element including the plurality of first conductive layers, the second conductive layer, the organic compound layer and the third conductive layer, and at least two light-emitting devices including a terminal for applying voltage to the organic light-emitting element are formed, and the substrate is cut with respect to each light-emitting device after the third conductive layer is formed.

16. The method for producing the organic light-emitting element according to claim 15, wherein the second conductive layer is formed at a section between the light-emitting devices adjacent to each other on the substrate.
